(19) Europäisches Patentamt
European Patent Office
Office européen des brevets

(11) **EP 1 852 961 A1**

(12) **EUROPEAN PATENT APPLICATION**
published in accordance with Art. 158(3) EPC

(43) Date of publication:
**07.11.2007 Bulletin 2007/45**

(51) Int Cl.:
*H02M 7/48* (2007.01)    *H01L 41/08* (2006.01)
*H02M 3/24* (2006.01)    *H05B 41/24* (2006.01)

(21) Application number: **06714072.3**

(22) Date of filing: **20.02.2006**

(86) International application number:
**PCT/JP2006/302931**

(87) International publication number:
**WO 2006/088176 (24.08.2006 Gazette 2006/34)**

(84) Designated Contracting States:
**DE FR**

(30) Priority:  **21.02.2005   JP   2005044484**

(71) Applicant: **Tamura Corporation**
**Tokyo 178-8511 (JP)**

(72) Inventors:
• **MIZUTANI, Akira**
  **iyoda, Sakado-si, Saitama, 3500214 (JP)**
• **YAMADA, Minoru**
  **iyoda, Sakado-si, Saitama, 3500214 (JP)**

(74) Representative: **Vossius & Partner**
**Siebertstrasse 4**
**81675 München (DE)**

(54)     **DRIVING CIRCUIT OF PIEZOELECTRIC TRANSFORMER**

(57)     [Problem]

A driving circuit of a piezoelectric transformer capable of placing insulation between a primary side and secondary side of each of piezoelectric transformers is provided.

[Means for solving]

In the driving circuit of piezoelectric transformers including piezoelectric transformers 11 to output a specified voltage to cold cathode fluorescent lamps 12, a driving section 50 to apply a voltage V used to drive the piezoelectric transformers 11, a frequency controlling section 51 to control the driving section 50, and a phase detecting section 52 to transmit a detecting signal to the frequency controlling section 51, primary sides of every two out of the piezoelectric transformers 11 are serially connected to one another, making up one pair of piezoelectric transformers 11 and every three pairs of said piezoelectric transformers 11 is connected in parallel to the driving unit and one end portion of each of the cold cathode fluorescent lamps 12 with a same plurality of numbers as for the piezoelectric transformers 11 is connected to each of secondary sides of the piezoelectric transformers 11 and facing end portions each being placed in another end portion of each of the cold cathode fluorescent lamp 12 are separated into two groups, each group being connected to one another and, as a result, currents output from the above piezoelectric transformers are cancelled out, which makes grounding unnecessary. Therefore, it is possible to provide insulation between the primary side and secondary side of each of the piezoelectric transformers 11 (Fig. 3).

Fig. 3

**EP 1 852 961 A1**

**Description**

TECHNICAL FIELD

The present invention relates to a driving circuit of a piezoelectric transformer to be used in a driving device for a cold cathode fluorescent lamp (CCFL) or in a high voltage generator for television sets (TVs), electronic copying machines, portable phones, or a like, which is capable of providing insulation between primary and secondary side of each piezoelectric transformer, detecting a phase difference among load currents to reduce variations in loads and controlling to decrease a difference in currents flowing through each of the loads.

BACKGROUND TECHNOLOGY

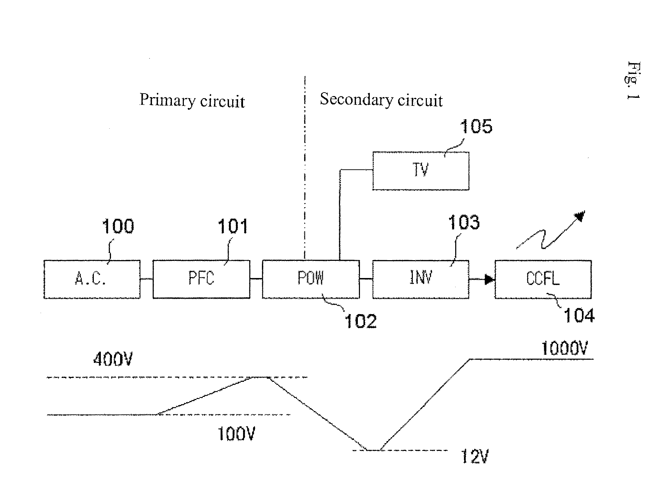

A piezoelectric transformer is a transformer configured to input a low voltage and to output a high voltage by utilizing a resonance phenomenon of a piezoelectric vibrator. The piezoelectric transformer is characterized in that an energy density of the piezoelectric vibrator is higher than that of an electromagnetic type transformer. Therefore, it is made possible to miniaturize the piezoelectric transformer, allowing it to be used for turning on/out a CCFL, backlight for a liquid crystal display device, small-sized high voltage power supply, or a like. A conventional technology is disclosed in Patent Reference 1 in which a CCFL is used as a backlight of a liquid crystal display panel and a piezoelectric transformer is used to light the CCFL. A piezoelectric inverter for liquid crystal TVs is a device realized by using the above technology. The piezoelectric inverter for liquid crystal TVs is being used as a lighting device to turn on/out a CCFL operating as a backlight source for liquid crystal TVs. Figure 1 is a block diagram showing configurations of circuits of a conventional liquid crystal TV and also a state of changes in voltage levels. In Fig. 1, an AC (alternating current) power source 100, a PFC (power factor improving circuit) 101, a POW (power switching unit) 102, an INV (piezoelectric inverter circuit) 103, a CCFL 104, and a TV (TV circuit) 105 are shown. A. specified voltage (for example, 100V) input from the AC power source 100. A power factor of the specified voltage input from the AC power source 100 is improved by the PFC 101. The voltage with the improved power factor is boosted up to a specified voltage (for example, 400V) and is then input to the POW 102. The voltage boosted by the PFC 101 up to the specified level (for example, 400V) is made to drop to a specified level (for example, 12V) by a switching circuit in the POW 102. The dropped voltage (for example, 12V) is input to the INV 103 and TV 105. In the INV 103, the specified voltage (for example, 12V) dropped by the POW 102 is boosted by an electromagnetic type transformer making up the INV 103 and is then boosted further by a piezoelectric transformer up to a specified level (for example, 1000V). The specified voltage (for example, 1000V) is applied to the CCFL 104 to light the CCFL 104. On the other hand, the specified voltage (for example, 12V) input to the TV 105 is used as a supply voltage in the TV 105.
Patent Reference 1: Japanese Patent Application Laid-open No. Hei 10 - 200174.

DISCLOSURE OF THE INVENTION

PROBLEMS TO BE SOLVED BY THE INVENTION

In the piezoelectric inverter for liquid crystal TVs described above, for example, after the voltage of 400V is made to drop to 12V by the POW 102, the voltage of 12V is boosted up to 1000V by the INV 103, which causes less effective operations. Moreover, the voltage has to be boosted about 100-fold and, therefore, when a single-plate type piezoelectric transformer is used individually, there has been a problem that an expected boost ratio is not obtained. On the other hand, when a laminated type piezoelectric transformer is used, though a voltage can be boosted individually, another problem has occurred that costs increase. To solve these problems, the INV 103 is equipped with an electromagnetic type transformer to allow a voltage to be boosted by a two-step boosting method. That is, at the first step, a voltage is boosted by the electromagnetic type transformer and, at the second step, the voltage is boosted by the piezoelectric transformer and the obtained specified voltage (for example, 1000V) is then output to the CCFL 104. As a result, another problem has occurred that the efficiency goes further worse.
To solve this problem, another circuit is provided in which an output voltage from the PFC101 is directly input to the INV103 without inputting to the POW 102 to improve the efficiency. By this method, the specified output voltage (for example, 400V) from the PFC 101 is input to the INV 103, which makes the boost ratio smaller. Therefore, the use of the single-plate piezoelectric transformer does not require the electromagnetic type transformer that has been used conventionally and, as a result, loss of power in the electromagnetic transformer and in the POW 102 can be suppressed, thus improving the efficiency.
However, if the voltage output from the PFC 101 is input directly to the INV 103, another problem occurs that it is impossible to provide insulation between a primary side of the piezoelectric transformer connected to the INV 103 and its secondary side. In the case of loads of the cold cathode tube or a like, from the viewpoint of safety, its primary side circuit is electrically and completely separated and insulated from its secondary side circuit. Conventionally, as shown in Fig. 1, the insulation could be placed between the primary and secondary sides by the electromagnetic type transformer connected to the POW 102. However, if the voltage output from the PFC 101 is input directly to the INV 103, since the voltage does not pass through the POW 102, it is necessary that the primary side circuit is fully separated and insulated from the secondary side by the INV 103. That is, a transformer is needed which is capable of providing electric and full insulation between primary and secondary circuits. Here, the transformer connected to the INV 103 conventionally includes both the electromagnetic type transformer and piezoelectric transformer, however, as described above, when an output voltage has to be boosted, the use of the electromagnetic type transformer is not required. However, the piezoelectric transformer has a three-terminal structure and, therefore, in addition to the output terminals of the piezoelectric transformer, a grounding line has to be routed from the primary circuit, which also causes another problem that insulation between the primary and secondary sides cannot be placed.

Moreover, in the liquid crystal TV, when a plurality of the CCFLs is used as a backlight for liquid crystal panel and a piezoelectric transformer is connected to each of the CCFLs, unless an amount of a tube current flowing through each of the CCFLs is made equal, a problem arises that nonuniformity in luminance of the backlight occurs. As a method for solving the problem, technology can be envisioned by which each tube current is controlled to make an amount of the tube current equal. However, if this technology is employed, other special control circuit is additionally required, which leads to a decrease in efficiency caused by power loss in the other circuit and to an increase in manufacturing costs.

In view of the above various problems to be solved, an object of the present invention is to provide a driving circuit of a piezoelectric transformer which is capable of placing insulation between a piezoelectric transformer's primary side and its secondary side.

Moreover, another object of the present invention is to provide a driving circuit of a piezoelectric transformer which is capable of suppressing variations in loads and reducing a difference in currents flowing through each load by detecting a phase of the load current at a central point of the load and by exerting control so that a phase difference between a load current and a driving voltage is 90 degrees.

## MEANS FOR SOLVING PROBLEMS

In order to achieve the above objects, the driving circuit of the piezoelectric transformer of the present invention includes piezoelectric transformers to output a specified voltage to loads, a driving unit to apply a voltage used to drive the piezoelectric transformers, a frequency controlling unit to control the driving unit, and a current detecting unit to transmit a detecting signal to the frequency controlling unit and is characterized in that primary sides of every two piezoelectric transformers are serially connected to one another, making up every one pair of piezoelectric transformers and one or more pairs of the piezoelectric transformers are connected in parallel to the driving unit and that one end portion of each of the loads with the same plurality of numbers as for the piezoelectric transformers is connected to each of secondary sides of the piezoelectric transformers and facing end portions each being placed in another end portion of each of the loads are separated into two groups, each group being connected to one another. By configuring as above, voltages output from the pairs of the above piezoelectric transformers are cancelled out and, as a result, grounding becomes unnecessary. Therefore, the driving circuit can provide insulation between the primary and secondary sides of the piezoelectric transformers.

Also, the driving circuit of the piezoelectric transformer of the present invention is characterized in that a phase difference between voltages output from the two piezoelectric transformers making up one pair of piezoelectric transformers is 180 degrees. Therefore, since the phase difference between voltages output from the two piezoelectric transformers making up one pair of piezoelectric transformers is 180 degrees, when each of the loads has floating capacitance, leakage currents flowing through the floating capacitor can be reduced.

Also, the driving circuit of the piezoelectric transformer of the present invention is characterized in that the current detecting section is configured to detect a current in each of facing end portions of the loads. This reduces changes in voltages in the current detecting section, thus enabling the replacement of components making up the above phase detecting section with ones each having a small voltage-withstand value.

Also, the driving circuit of the piezoelectric transformer of the present invention is characterized in that the current detecting section also serves as a phase detecting section to detect a phase difference among load currents. Therefore, by detecting a phase of the load current and by exerting control so that a phase difference between a total sum of each of the load currents and the driving voltage of each of the piezoelectric transformers is - 90 degrees, variations in loads can be suppressed and a difference in currents flowing through each load can be reduced.

Also, another driving circuit of a piezoelectric transformer of the present invention includes piezoelectric transformers to output a specified voltage to loads, a driving section to apply a voltage used to drive the piezoelectric transformers, a frequency controlling unit to control the driving section, and a current detecting section to transmit a detecting signal to the frequency controlling section and is characterized in that primary sides of every two piezoelectric transformers are connected in parallel to one another, making up every one pair of piezoelectric transformers and one or more pairs of the piezoelectric transformers are connected in parallel to the driving unit and that one end portion of each of the loads with the same plurality of numbers as for the piezoelectric transformers is connected to each of secondary sides of the piezoelectric transformers and facing end portions each being placed in another end portion of each of the loads are separated into two groups, each group being connected to one another, and that the current detecting section also serving as a phase detecting unit to detect a phase difference among load currents.

Thus, even if the above piezoelectric transformers are connected in parallel to one another, making every one pair of piezoelectric transformers, voltages output from the piezoelectric transformers are cancelled out, which makes grounding unnecessary. This enables primary and secondary sides of the piezoelectric transformers to be insulated from each other. Therefore, by detecting a phase difference among load currents and by exerting control so that a phase difference between a total sum of each of the load currents and the driving voltage of each of the piezoelectric transformers is - 90 degrees, variations in each of the loads can be suppressed and a difference in currents flowing through each of the loads can be reduced.

Furthermore, still another driving circuit of the present invention of the present invention includes piezoelectric transformers to output a specified voltage to U-shaped cold cathode tubes, a driving section to apply a voltage used to drive the piezoelectric transformers, a frequency controlling section to control the driving unit, and a current detecting section to transmit a detecting signal to the frequency controlling section and is characterized in that the driving section is serially connected to every two piezoelectric transformers and every two piezoelectric transformers is serially connected to the U-shaped cold cathode tubes, and that the current detecting section detects a phase of each load current in electrodes in the cold cathode tubes.

Therefore, also in the case of using the U-shaped cold cathode tube, voltages output from every two piezoelectric transformers are cancelled out, thereby negating the need of grounding. As a result, insulation can be provided between primary and secondary sides of the piezoelectric transformers. Moreover, the cold cathode tube can be equivalently approximated to a pure resistor and, therefore, the load voltage is in phase with the load current. Since the load voltage phase is considered also as the load current phase, by controlling so that a phase difference between a total sum of each of load voltages and the driving voltage of each of the piezoelectric transformers becomes - 90 degrees, variations in each of the loads can be suppressed and a difference in currents flowing through each of the loads can be reduced.

EFFECTS OF THE INVENTION

According to the present invention, the driving circuit of the piezoelectric transformer can be provided which is capable of placing insulation between primary and secondary sides of the piezoelectric transformers. Also the driving circuit of the piezoelectric transformer can be provided which is capable of suppressing variations in loads and reducing a difference in currents flowing through each of the loads by detecting, using the phase detecting section, a phase of the load current at a central point of each of the loads and by exerting control so that a phase difference between a load current and a driving voltage is 90 degrees.

BEST MODE FOR CARRYING OUT THE INVENTION

The first embodiment of the present invention is described by referring to drawings. It is noted that the embodiments explained below do not put restriction on the inventions stated in claims of the present invention and all the combinations of characteristics described in the embodiments are not always necessary as means of solving the problems of the invention.

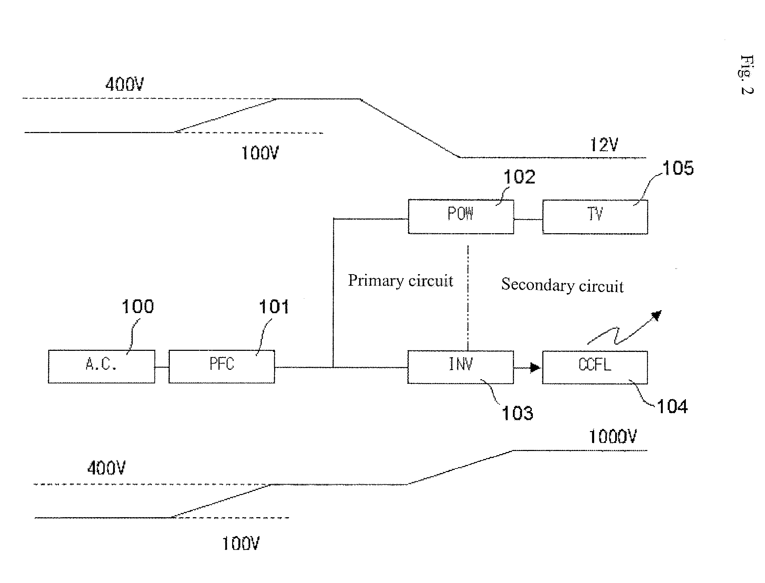

First, circuit configurations of a liquid crystal TV of the embodiment is described by referring to Fig. 2. Figure 2 is a block diagram showing circuit configurations of the liquid crystal TV according to the embodiment of the present invention and also showing states of changes in voltage levels. The piezoelectric inverter for the liquid crystal TV shown in Fig. 2 is used as a lighting device to turn on/out a cold cathode fluorescent lamp (CCFL) to be used in a light source of a backlight of the liquid crystal TV. In Fig. 2, an AC (alternating current) power source 100, a PFC (power factor improving circuit) 101, a POW (power switching unit) 102, an INV (piezoelectric inverter circuit) 103, a CCFL 104, and a TV circuit 105 are shown. A specified voltage (for example, 100V) input from the AC power source 100, after the improvement of its power factor in the PFC 101, is boosted up to a specified level (for example, 4000V). Unlike the conventional circuit, a specified voltage (for example, 400V) is input to the POW 102 and INV 103. The voltage boosted by the PFC 101 up to the specified level (for example, 400V) is made to drop to a specified level (for example, 12V) by a switching circuit in the POW 102. The voltage (for example, 12V) is input to the TV circuit 105 and is used as supply power in the TV 105.

On the other hand, the voltage already boosted up to the specified level (for example, 400V) after the improvement of its power factor in the PFC 101 is again boosted up to a specified voltage (for 1000V) by using a single-plate type piezoelectric transformer constituting the INV 103. The CCFL 104 is lit by the application of the specified voltage (for example, 1000V). Therefore, by changing the circuit configurations from the configurations shown in Fig. 1 to those shown in Fig. 2, a boost ratio can be lowered and, as a result, it is made possible to boost a voltage by using the single-plate type piezoelectric transformer. That is, according to the circuit of the embodiment, the electromagnetic type transformer connected to the conventional INV 103 and required in the two-step boosting method becomes unnecessary. As a result, the removal of the electromagnetic type transformer can improve the operating efficiency. Moreover, unlike in the conventional case, since a voltage does not pass through the POW 102, no loss of power occurs, which can further improve the efficiency. Moreover, though no change occurs in the voltage to be input to the POW 102, a flow of a current to be input is branched and, therefore, each component constituting the POW 102 is allowed to become small in capacity and an effect by a decrease in manufacturing costs and in size can be obtained.

However, when the circuit configurations shown in Fig. 2 are employed, a problem arises that it is impossible to place insulation between the primary circuit and secondary circuit. To solve this problem, according to the embodiment of the present invention, the arrangement and configurations of the driving circuit of the piezoelectric transformer are improved. Hereinafter, the driving circuit of the piezoelectric transformer of the present invention is described.

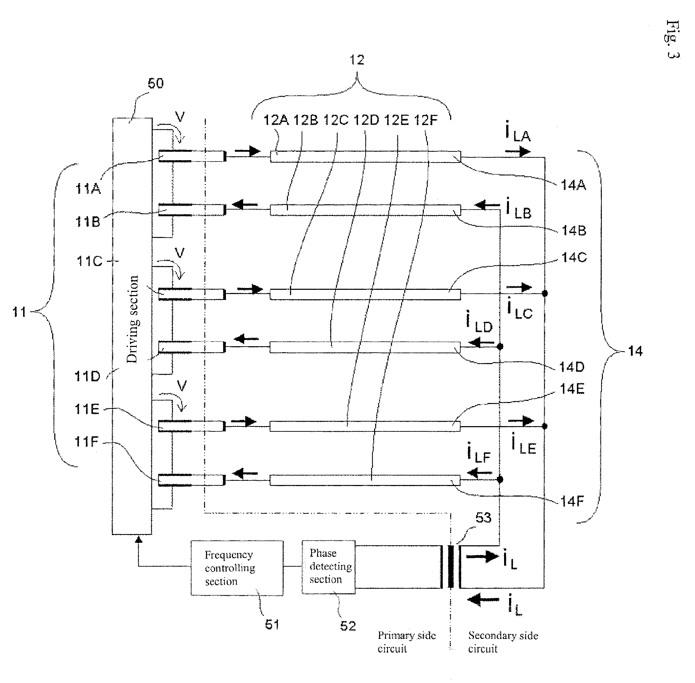

Figure 3 is a block diagram showing the driving circuit of the piezoelectric transformer according to the first embodiment of the present invention. The driving circuit shown in Fig. 3 includes piezoelectric transformers 11A to 11F, a driving section 50, a frequency controlling section 51, a phase detecting section 52, and a transformer 53. Moreover, cold cathode fluorescent lamps (CCFLs) 12A to 12F operating as loads are shown in Fig. 3. Each of the above piezoelectric transformers 11A to 11F is a single-plate piezoelectric transformer and each of the piezoelectric transformers 11A to 11F is serially connected to each of the CCFLs in a manner in which, for example, the piezoelectric transformer 11A corresponds to the CCFL 12A. Therefore, a driving voltage V is input from the driving section 50 to each of the piezoelectric transformers 11A to 11F and a specified voltage is output from each of the piezoelectric transformers 11A to 11F to each of the CCFLs 12A to 12F for lighting. Each of electrodes 14A to 14F placed one end of each of the CCFLs 12A to 12F is connected to a transformer 53. The facing end electrodes 14A, 14C, and 14E out of the facing end electrodes 14A to 14F make up one group of the facing end electrodes in a manner in which the facing end electrodes 14A, 14C, and 14E are connected to one another and the facing end electrodes 14B, 14D, and 14F out of the facing end electrodes 14A to 14F make up another group of the facing end electrodes in a manner in which the facing end electrodes 14B, 14D, and 14F are connected to one another. Each of the above two groups of the facing end electrodes is connected to each terminal (not shown) of the transformer 53. By configuring as above, load currents L described later are fed back to the transformer's primary side.

The transformer 53 performs current transformation on load currents iL being a total amount of each of the load currents iLA to iLF flown from the facing end electrodes 14A to 14F and outputs the transformed current to the phase detecting section 52 serving also as a phase controlling section. The phase detecting section 52 detects a phase of a total sum of each of the load currents iL input from the transformer 53 and outputs the detected signal to the frequency controlling section 51. The frequency controlling section 51, when receiving the above detected signal, compares a phase of the total sum of each of load currents iL with a phase of the driving voltage V and judges whether or not a phase difference between the total sum of each of the load currents iL and the driving voltage V is - 90 degrees. After that, the frequency controlling section 51 controls the driving section 50 so that the above phase difference is kept at - 90 degrees and inputs the driving voltage to the piezoelectric transformer 11. Therefore, through the transformer 53 and phase detecting section 52 flow the total sum of each of the load currents iL at a central point of the CCFLs 12A and 12B. This causes changes in voltages passing through the phase detecting section 52 to be reduced which enables the replacement of components making up the above phase detecting section 52 and transformer 53 with ones each having a small voltage-withstand value.

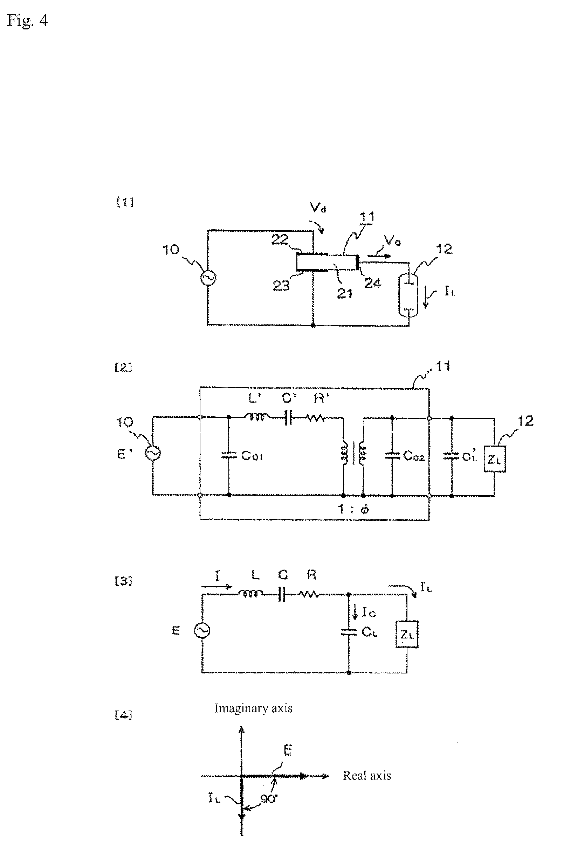

As shown in Fig. 3, every two piezoelectric transformers is connected in series to the driving section 50. The connection is established in a manner in which a loop occurs, for example, from the driving section 50 through the piezoelectric transformer 11A and the piezoelectric transformer 11B back to the driving section 50. Moreover, the connection is further established in a manner in which a loop occurs, for example, from the piezoelectric transformer 11A - CCFL 12A - facing end electrode 14A - transformer 53 - facing end electrode 14P - CCFL 12B to the piezoelectric transformer 11B. Furthermore, the piezoelectric transformers 11A and 11B are selected so that a phase difference in voltage between the piezoelectric transformer 11A and the piezoelectric transformer 11B becomes 180 degrees. As a result, for example, the facing end electrode 14A placed at one end of the CCFL 12A and the facing end electrode 14B placed at one end of the CCFL 12B are connected to each other through the transformer 53 and, therefore, voltages output from the piezoelectric transformers 11A and 11B are cancelled out each other. As a result, unlike in the conventional case, the grounding line is no required and, therefore, it is made possible to provide electric separation and insulation between the transformer's primary side and its secondary side. Moreover, as shown in Fig. 3, control is exerted so that a phase difference in voltages not only between the piezoelectric transformers 11A and 11B connected serially to each other but also between the piezoelectric transformers being not connected to each other and being adjacent to each other, such as between the piezoelectric transformers 11B and 11C, becomes 180 degrees. By controlling as above, leakage currents flowing through an electrostatic capacitance (floating capacitance) CL' (see Fig. 4) that each of the CCFLs 12A to 12F has can be reduced.

In the circuit configurations shown in Fig. 3, the voltage output from each of the piezoelectric transformers 11A to 11F to each of the CCFLs 12A to 12F needs to be synchronized. The above output voltage is as high as, for example, 1000V, which causes an electrostatic noise source to a liquid crystal screen, thus presenting a problem. To solve this problem, control is exerted so that a phase difference among voltages output from the piezoelectric transformers 11A to 11F to the CCFLs 12A to 12F becomes 180 degrees for synchronization.

However, for example, a resonance characteristic of the piezoelectric transformer 11A does not always coincide with that of the piezoelectric transformer 11B and, as a result, there are cases where a phase difference in voltages among the piezoelectric transformers 11A to 11F is not 180 degrees. Therefore, in the driving circuit of the first embodiment shown in Fig. 3, for example, the piezoelectric transformers 11A and 11B are serially connected to the driving section 50. This causes one resonant circuit to be formed and a resonant angular frequency is calculated by using the formed resonant circuit. By inputting a driving voltage V having the above resonant angular frequency, for example, to the piezoelectric transformers 11A and 11B, a phase difference in voltage among the piezoelectric transformers 11 is controlled to become 180 degrees, even though each of the piezoelectric transformers 11 has a resonant characteristic being different from one another. Moreover, two piezoelectric transformers 11 may be connected in parallel to the driving section 50. However, in this case, two resonant circuits are formed, making it difficult to exert control.

Moreover, amounts of each of the load currents iLA to iLF flowing through each of the CCFLs 12A to 12F have to be the same. If the amounts of the currents are not the same, a problem arises that nonuniformity of luminance of the backlight occurs. Therefore, in the driving circuit of the first embodiment shown in Fig. 3, a phase of a total sum of the load currents iL is compared with a phase of the driving voltage V and whether or not a phase difference between the total sum of each of the load currents iL and the driving voltage V is - 90 degrees is judged and control is exerted so that the above phase difference becomes - 90 degrees. By operating as above, a current difference among load currents iLA to iLF flowing through the CCFLs 12 can be controlled so as to be made small.

The reason why the difference in currents can be controlled so as to be made small by exerting control so that the phase difference between a total sum of each of the load currents iL and a driving voltage V is - 90 degrees is described below.

Figure 4 is a diagram explaining the fact that, by exerting control so that the load current IL lags the driving voltage Vd by 90 degrees, a value of the load current IL can be controlled. Figure 4[1] is a simplified circuit diagram. Figure 4[2] is a diagram of an equivalent circuit of the circuit shown in Fig. 4[1]. Figure 4[3] is a diagram of an equivalent circuit of the circuit shown in Fig. 4[2]. Figure 4[4] is a vector diagram showing a relation between the driving voltage Vd and load current IL. Hereinafter, operations are explained by referring to drawings.

In the driving device 10, an angular frequency $\omega 0$ of a driving voltage Vd occurring on a primary side of each of the piezoelectric transformers 11 to the secondary side of which each of the CCFLs 12 is connected, when an impendece of each of the CCFLs 12 is made infinitely large, is a series resonant angular frequency provided by an equivalent circuit on an output side of the driving device 10. In each of the piezoelectric transformers 11, a primary electrodes 22 and 23 and secondary electrode 24 are mounted on a piezoelectric vibration body 21 and its primary side is polarized in the thickness direction (in an up and down direction in Fig. 4 [1]) and its secondary side is polarized in the length direction (in a right and left direction in Fig. 4[1]). These components are housed in a resin case (not shown). The primary electrode 22 faces the primary electrode 23 with the piezoelectric vibration body 21 interposed between them. The piezoelectric vibration body 21 is made of piezoelectric ceramic such as PXT (porous lead zirconate titanate) and is plate-shaped (rectangular parallelepiped shaped). The primary electrodes 22 and 23 extend from one end of the piezoelectric vibration body 21 up to a half of the whole length of the piezoelectric vibration body 21 and the secondary electrode 24 is mounted on another end. The input of the driving voltage Vd having a natural resonance frequency determined by a length dimension to the primary side causes a strong mechanical vibration induced by an inverse piezoelectric effect and, as a result, a high output voltage VO corresponding to the degree of the vibration is output from the secondary side. The output voltage V0 is applied to each of the CCFLs 12.

According to the driving device 10, though the configurations are simplified, irrespective of the magnitude of impedance ZL, the load current IL can be made constant. Therefore, even if the impedance ZL of each of the CCFLs 12 changes, the load current IL is allowed to be constant ordinarily. The reason for that is described in detail below. The circuit shown in Fig. 4 [1] can be represented by the equivalent circuit shown in Fig. 4[2]. In Fig. 4[2], each of the piezoelectric transformers 11 is alternatively represented by an ideal transformer having electrostatic capacitances C01, C02, and C', an inductance L', a resistance R', and a turns ratio of 1: $\phi$ and a like. The driving voltage Vd is expressed as a driving voltage E'. The electrostatic capacitance CL' is floating capacitance of each of the CCFLs 12.

The equivalent circuit shown in Fig. 4[2] can be further represented by the equivalent circuit shown in Fig. 4[3] obtained when the piezoelectric transformers 11 side are seen from the CCFLs 12 side. In the equivalent circuit shown in Fig. 4[3], $E = \phi E'$, $L = \phi 2L'$, $C = C'/\phi 2$, $R = \phi 2R'$, $CL = C02 + CL'$. The equivalent circuit shown in Fig. 4[3] has inductance L, resistance R, electrostatic capacitance C02, and electrostatic capacitance CL, all of which are connected in series and impedance ZL of each of the CCFL12 being connected in parallel to the electrostatic capacitance CL. The impedance ZL is allowed to contain an inductance component and/or electrostatic capacitance component, in addition to resistance component. Moreover, the circuit shown in Fig. 4[1] is simplified by omitting accessory components, however, even if these accessory components or a like are connected, the circuit can be finally represented by the equivalent circuit shown in Fig. 4[3].

In the circuit shown in Fig. 4[3], the following equation holds:

$$I = IC + IL \cdots (1)$$

where I denotes all currents output from the driving circuit 10, IC denotes a current flowing through the electrostatic capacitor CL, and IL denotes a load current flowing through the impedance ZL. Moreover, since the voltage across the impedance ZL is ILZL and the voltage across the electrostatic capacitor CL is also ILZL, the following equation holds:

$$IC = j\omega CLILZL \cdots (2)$$

Therefore, from the above equations (1) and (2), all the current I can be shown as follows:

$$I = IC + IL = IL(1 + j\omega CLZL) \cdots (3)$$

On the other hand, from the equation (3), a voltage drop by L, C, and R can be written as follows:

$$\{R + j(\omega L - 1/\omega C)\}I = \{R + j(\omega L - 1/\omega C)\}IL(1 + j\omega CLZL) =$$
$$RIL(1 + j\omega CLZL) + ILj(\omega L - 1/\omega C)(1 + j\omega CLZL)$$
$$= \{R \cdot (\omega L - 1/\omega C)\omega CLZL\}IL + j\{\omega CLZLR + (\omega L - 1/\omega C)\}IL$$
$$\cdots (4)$$

Therefore, from the equation (4), the following equation holds:

$$E = \{R \cdot (\omega L - 1/\omega C)\omega CLZL\}IL + j\{\omega CLZLR + (\omega L - 1/\omega C)\}IL + ZLIL \cdots (5)$$

As a result, from the equation (5), the load current IL is given by the following equation:

$$IL = E / [\{R + ZL - (\omega L - 1/\omega C)\omega CLZL\} + j\{\omega CLZLR + (\omega L - 1/\omega C)\}] \cdots (6)$$

Here, $\omega$ is defined by the following equation.

$$\omega = 1/\sqrt{[L\{CCL/(C + CL)\}]} = \omega 0 \cdots (7)$$

The above angular frequency $\omega 0$ is a series resonant angular frequency of a series resonant circuit made up of L, C, R, and CL, obtained when the impedance ZL is made infinitely large in the circuit shown in Fig. 4(3). At this time, the following equation holds:

$$(\omega L - 1/\omega C) = 1/\omega 0 CL \cdots (8)$$

By substituting the equations (7) and (8) for the equation (6), the following equation can be obtained:

$$IL \mid \omega = \omega 0 = E/\{R+j(\omega 0 CLZLR + 1/\omega 0 CL)\} \cdots (9)$$

Ordinarily, $R \ll 1/\omega 0 CL$ and, therefore, the following equation holds:

$$IL \mid \omega = \omega 0 \fallingdotseq E/j(1/\omega 0 CL) = -j\omega 0 CL \cdot E \cdots (10)$$

Therefore, when the angular frequency of the driving voltage E is given by the equation (7), as is apparent from the equation (10), the load current IL becomes constant irrespective of impedance ZL of each of the CCFLs 12. At this time point, as shown in Fig. 4[4], the load current IL lags the driving voltage E by 90 degrees.

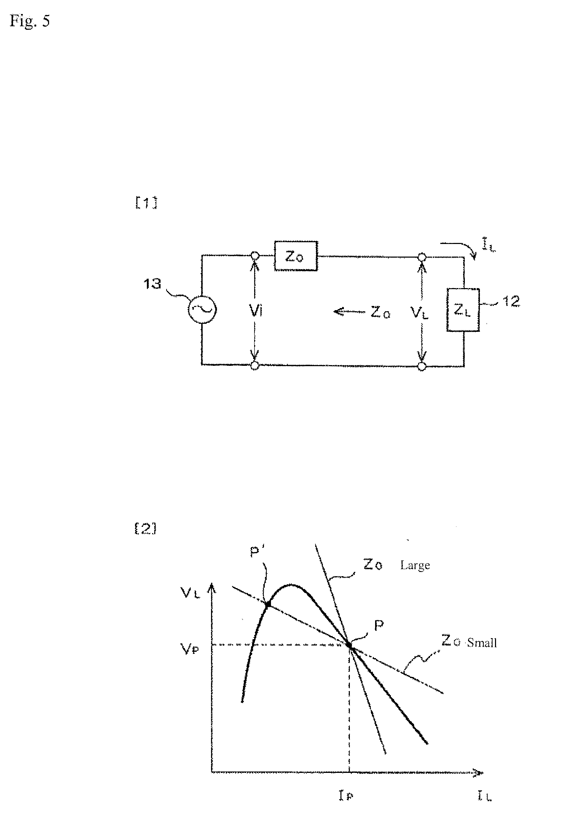

Figure 5 is a diagram explaining a current-voltage characteristic of each of the CCFLs 12. Figure 5[1] is an equivalent circuit. Figure 5[2] is a diagram showing the current-voltage characteristic of each of the CCFLs 12. The current-voltage characteristic is described by referring to Figs. 4 and 5.

In Fig. 5[1], instead of the driving device 10 and piezoelectric transformers 11 shown in Fig. 4[1], an alternating current voltage source 13 and an output impedance Z0 are used. As a result, the output impedance Z0 and each of the CCFLs 12 are connected in series to the alternating current voltage source 13. Here, the linear load line is given by the following equation:

$$VL = -Z01L + Vi \cdots (11)$$

where VL denotes a voltage across each of the CCFLs 12, IL denotes a load current flowing through each of the CCFLs 12 and Vi denotes an output voltage of the alternating current voltage source 13. On the other hand, as shown in Fig. 5[2], in each of the CCFLs 12, a negative resistance partially appears in the current - voltage characteristic. The negative resistance is a characteristic in which the more the load current IL increases, the more the voltage VL across each of the CCFLs 12 decreases. It is now assumed that, in Fig. 5[2], an operating point of each of the CCFLs 12 is placed at a point P (Ip, Vp). However, if the impedance is small, a slope of the linear load line becomes small and, as a result, besides the operating point P, another operating point P' appears. This causes a plurality of operating points to appear, which leads to unstable operations of each of the CCFLs 12.

In contrast, in the embodiment of the present invention, when the alternating current voltage source 13 side is seen from each of the CCFLs 12, the alternating current voltage source 13 side serves as a constant current source. This is because the load current IL flowing each of the CCFLs 12 becomes constant irrespective of the impedance ZL of each of the CCFLs 12. This allows the output impedance ZO of the alternating current voltage source 13 to be considered as being approximately infinitely large. As a result, the slope of the load current becomes large and the operating point of each of the CCFLs 12 is determined as only one point P, thus realizing stable operations of each of the CCFLs 12.

Thus, by exerting control so that a phase difference among the load currents IL and the driving voltage E is - 90 degrees, the load currents IL can be theoretically made constant irrespective of the impedance ZL of each of the CCFLs 12. However, as described above, since variations in resonant characteristics occur in the piezoelectric transformers 11, the load current IL does not always become constant. However, it is made possible to exert control so that a difference in currents flowing through the load current IL becomes small.

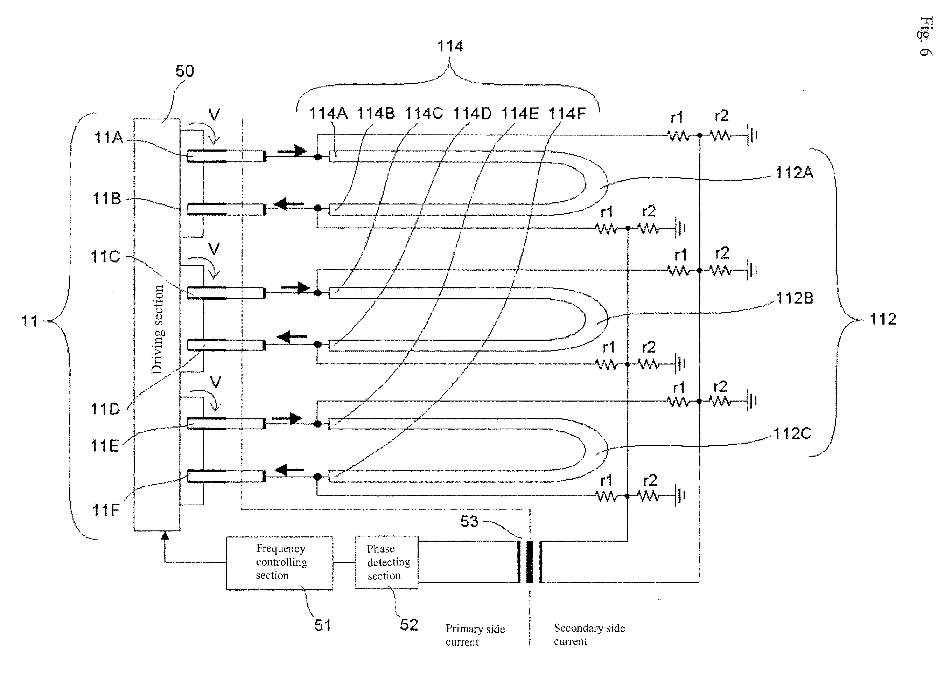

Next, the second embodiment of the present invention is described by referring to drawings. It is noted that the embodiment explained below do not put restriction on the inventions stated in claims of the present invention and all the combinations of characteristics described in the embodiments are not always necessary as means of solving the problem of the invention. Moreover, in the drawing of the second embodiment, the same reference numbers are assigned to components having the same functions as those in the first embodiment and their detailed descriptions are omitted accordingly. Figure 6 is a driving circuit of the piezoelectric transformer according to the second embodiment of the present invention. Configurations of the driving circuit shown in Fig. 6 are the same as those in the first embodiment except that the CCFLs 112A to 112C are formed to be U-shaped. Therefore, configurations of the piezoelectric transformers 11A to 11F, driving section 50, frequency controlling section 51, phase detecting section 52, and transformer 53 in the second embodiment are the same as those in the first embodiment. Thus, each of the CCFL 112 being a charactering portion of the second embodiment is described.

Each of the U-shaped CCFLs 112A to 112C has two electrode out of electrodes 114A to 114F. Each electrode 114 is connected to each of the piezoelectric transformers 11 and resistor r1. For example, the electrode 114A is connected to the piezoelectric transformer 11A and resistor r1. The resistor r1 is connected to terminals of both the resistor r2 and transformer 53 and other terminal of the resistor r2 connected to the resistor r1 is grounded. The resistor r1 resistor r2 and grounding terminal, as a whole, make up a voltage divider. The voltage divider divides an output voltage of each of the piezoelectric transformers 11 input to each of the CCFLs 12 and outputs the divided voltage to the transformer 53. Every two piezoelectric transformers 11 is serially connected to the driving section 50 and each of the CCFLs 114. The connection is established in a manner in which a loop occurs, for example, from the piezoelectric transformer 11A through the electrode 114A and the CCFL 112A and the electrode 114B back to the piezoelectric transformer 11B. Similarly, the connection is established in a manner in which a loop occurs from the piezoelectric transformer 11C - electrode 114C - CCFL 112B - electrode 114D to the piezoelectric transformer 11F and from the piezoelectric transformer 11E - electrode 114E - CCFL 112C - electrode 114F to the piezoelectric transformer 11F. As in the case of the first embodiment, a phase difference between voltages output from the piezoelectric transformers 11A and 11B, between voltages output from the piezoelectric transformers 11C and 11D, and between voltages output from the piezoelectric transformers 11E and 11F is 180 degrees. As a result, insulation can be provided between the primary side and secondary side of each of the piezoelectric transformers 11.

Moreover, as described above, the electrode 114 is connected via the resistor r1 to the transformer 53. The connection is established in a manner in which a loop occurs, for example, from the piezoelectric transformer 11A - resistor r1 - transformer 53 - resistor r1 to the piezoelectric transformer 11B. Similarly, the connection is established in a manner in which a loop occurs from the piezoelectric transformer 11C - resistor r1 - transformer 53 - resistor r1 to the piezoelectric transformer 11D and from the piezoelectric transformer 11E - resistor r1 - transformer 53 - resistor r1 to the piezoelectric transformer 11F. That is, a total sum of each of the voltages output from each of the piezoelectric transformers 11 is divided and the divided output is input to the transformer 53.

Here, each of the CCFLs 112 can be generally considered as a resistance load having an electrostatic capacitance (floating capacitance) CL'. Moreover, in the case of the second embodiment, as in the first embodiment, since there is a phase difference of 180 degrees between voltages output from each of the piezoelectric transformers 11 being adjacent to one another, leakage current flowing into the above electrostatic capacitor CL' can be reduced. Here, a waveform of a voltage obtained by dividing a total sum of each of the voltages input to the transformer 53 can be considered to be a waveform of a current. That is, the transformer 53 changes the waveform of divided voltage and inputs the changed voltage to the phase detecting section 52. The phase detecting section 52 serving as a phase controlling section is configured to detect a phase of the total sum of each of the voltages output from the transformer 53 and outputs a detecting signal to the frequency controlling section 51. The frequency controlling section 51, when receiving the above detecting signal, compares a phase of the total sum of each output voltages with a phase of the driving voltage V and judges whether or not a phase difference between the total sum of the output voltage and the driving voltage is - 90 degrees. Then, the frequency controlling section 51 exerts control so that the above phase difference is kept at - 90 degrees and inputs the driving voltage V to each of the piezoelectric transformers 11. Therefore, it is possible to exert control so that a difference in load currents flowing through each of the CCFLs 112.

As described above, the driving circuit of the piezoelectric transformer of the first embodiment includes the piezoelectric transformers 11 to output a specified voltage to the CCFLs 12 operating as the loads, the driving section 50 to supply a voltage V used to drive the piezoelectric transformers 11, the frequency controlling section 51 to control the driving section 50, and the phase detecting section 52 serving as a current detecting section to transmit a detecting signal to the frequency controlling section 51. In the above driving circuit, primary sides of every two piezoelectric transformers are serially connected to each other to make up one pair of piezoelectric transformers 11 and every three pairs of piezoelectric transformers 11 is connected in parallel to the driving section 50 and one end portion of each of the CCFLs 12 with a same plurality of numbers as for the piezoelectric transformers 11 is connected to each of secondary sides of the piezoelectric transformers 11 and facing end portions each being placed in another end portion of each of the CCFLs 12 are separated into two groups, each group being connected to one another. By configuring as above, voltages output from the pairs of the above piezoelectric transformers 11 are cancelled out and, as a result, grounding becomes unnecessary. Therefore, the driving circuit can provide insulation between the primary and secondary sides of the piezoelectric transformers 11.

In addition, in the driving circuit of the piezoelectric transformer of the first embodiment, since a phase difference between voltages output from the two piezoelectric transformers 11 making up one pair of piezoelectric transformers is 180 degrees, when each of the CCFLs 12 has floating capacitance CL', the leakage current flowing through the floating capacitor CL' can be reduced.

Furthermore, in the driving circuit of the piezoelectric transformer of the first embodiment, the phase detecting section 52 detects the load current iL flowing in the facing end electrode 14 of each of the CCFLs 12. This causes changes in voltage passing through the phase detecting section 52 to be reduced which enables the replacement of present components constituting the above phase detecting section 52 and transformer 53 with ones each having a small voltage-withstand value.

Moreover, in the driving circuit of the piezoelectric transformer of the first embodiment, the phase detecting section 52 serving as a current detecting section adapted to detect a phase difference in the load currents iL to exert control so that a phase difference between a total sum of each of the load currents iL and the driving voltage V of each of the piezoelectric transformers 11 is - 90 degrees, which enables variations in load in each of the CCFLs 12 to be suppressed and that a difference in currents flowing through each of the CCFLs 12 is reduced.

Furthermore, the driving circuit of the piezoelectric transformer of the first embodiment is made up of each of the piezoelectric transformers 11 to output a specified voltage to each of the CCFLs 12, the driving circuit 50 to supply a voltage V used to drive the piezoelectric transformers 11, the frequency controlling section 51 to control the driving circuit, and the phase detecting section 52 serving as a current controlling section to transmit a detecting signal to the frequency controlling section 51. Alternatively, the above driving circuit may be configured in a manner in which the secondary sides of every two piezoelectric transformers 11 are connected in parallel to one another so that one pair of piezoelectric transformers 11 is formed and one or more piezoelectric transformers 11 are connected in parallel to the driving section 50 and one end of each piezoelectric transformer of each of the CCFLs 12 with the same plural numbers as for the piezoelectric transformers 11 is connected to the secondary side of each of the piezoelectric transformers 11 and the facing end electrodes 14 placed on another end is separated into two groups, each group being connected to one another and the phase detecting section 52 detects a phase difference in the load current iL. Thus, even when the above piezoelectric transformers 11 are connected in parallel and one pair of piezoelectric transformers 11 is formed, voltages output from each of the piezoelectric transformers are cancelled out, thereby negating the need of grounding and, therefore, insulation can be placed between the primary and secondary sides of each of the piezoelectric transformers 11. Moreover, by detecting a phase difference among load currents iL and by exerting control so that the phase difference between a total sum of each of the load currents iL and the driving voltage is - 90 degrees, variations in load in each of the CCFLs 12 can be suppressed and a difference in currents flowing through each of the CCFL 12 can be reduced.

Furthermore, the driving circuit of the piezoelectric transformer of the second embodiment includes the piezoelectric transformers 11 to output a specified voltage to the U-shaped CCFLs 112, the driving section 50 to supply a voltage V used for driving the piezoelectric transformers 11, the frequency controlling section 51 to control the driving section 50, and a phase detecting section 52 serving as a current controlling section to transmit a detecting signal to the frequency controlling section 51. Also, the driving circuit 50 is serially connected to every two piezoelectric transformers 11 and every two piezoelectric transformers 11 is serially connected to the CCFLs 112 and the phase detecting section 52 detects a phase of load voltages in each of the electrodes 114 of each of the CCFLs 112.

By configuring as above, in the U-shaped CCFLs 112, voltages output from every two piezoelectric transformers 11 are cancelled out and, as a result, grounding becomes unnecessary, thus enabling insulation to be placed between the primary and secondary sides of each of the piezoelectric transformers 11. Moreover, each of the CCFLs 112 can be equivalently approximated to a pure resistor and, therefore, the load voltage is in phase with the load current iL. As a result, since the load voltage phase is considered also to be the load current iL phase, by controlling so that a phase difference between the total sum of each of the load voltages and the driving voltage V of each of the piezoelectric transformers 11 becomes - 90 degrees, variations in load in each of the CCFLs 112 can be suppressed and a difference in currents flowing through each of the CCFLs 112 can be reduced.

Moreover, it is understood that the present invention is not limited to the embodiments described above and can be applied to other various embodiments without departing from the scope of the present invention. For example, in the above embodiments, the CCFL 12 (first embodiment) and 112 (second embodiment) are used as loads, however, the present invention is not limited to these and other loads can be applied. Also, in the above embodiments, the straight-pipe shaped CCFL (first embodiment) and U-shaped CCFL (second embodiment) are used, however, its shape is not limited to these and other shapes can be applied as well.

In the above embodiments, a plurality of piezoelectric transformers 11A to 11F are used, whereas one driving section 50, one frequency controlling section 51, one phase detecting section 52, and one transformer 53 are placed. However, the present invention is not limited to the configurations and a plurality of driving sections, a plurality of frequency controlling sections, a plurality of phase detecting sections, and a plurality of transformers may be used. For example, a plurality of driving sections 50 may be placed and the number of other components may be only one. For every pair of piezoelectric transformers made up of two piezoelectric transformers 11, one transformer 53 and one phase detecting section 52 may be connected. By configuring like this, more accurate controlling is made possible. Also, for every pair of piezoelectric transformers made up of two piezoelectric transformers 11, the driving section 50 may be connected.

Also, in the above embodiments, a pair of piezoelectric transformers is made up of two piezoelectric transformers 11, however, the present invention is not limited to this and one group of the piezoelectric transformers 11 may be made up of a plurality of piezoelectric transformers 11.

Furthermore, in the above embodiments, the driving circuit has six piezoelectric transformers 11, however, the present invention is not limited to this and the present invention can be applied to a driving circuit having a plurality of piezoelectric transformers 11.

INDUSTRIAL USABILITY

The present invention can be applied to any driving circuit, so long as the circuit is for a piezoelectric transformer, including a driving device for a cold cathode fluorescent lamp (CCFL), for television sets (TVs), electronic copying machines, portable phones, or a like.

BRIEF DESCRIPTION OF DRAWINGS

Figure 1 is a block diagram showing circuit configurations of a conventional liquid crystal TV and also a state of changes in voltage levels.
Figure 2 is a block diagram showing circuit configurations of a liquid crystal TV of the present invention and also a state of changes in voltage levels.
Figure 3 shows a driving circuit of a piezoelectric transformer according to the first embodiment of the present invention.
Figure 4 is a diagram explaining the fact that, by exerting control so that a load current lags a driving voltage by 90 degrees, a value of the load current IL can be controlled.
Figure 5 is a diagram explaining a current-voltage characteristic of the cold cathode fluorescent lamp CCFL.
Figure 6 is a driving circuit of the piezoelectric transformer according to the second embodiment of the present invention.

EXPLANATION OF LETTERS OR NUMERALS

10: driving device; 11, 11A, 11B, 11C, 11D, 11E, 11F: piezoelectric transformer; 12, 12A, 12B, 12C, 12D, 12E, 12F: cold cathode fluorescent lamp (CCFL); 13: alternating current voltage source; 14, 14A, 14B, 14C, 14D, 14E, 14F: facing end electrode; 21: piezoelectric vibration body; 22, 23: primary electrode, 24: secondary electrode; 50: driving section; 51: frequency controlling section; 52: phase detecting section; 53: transformer; 100: AC (alternating current) power source; 101: PFC (power factor improving circuit); 102: POW (power switching unit); 103 conventional INV (piezoelectric inverter circuit); 104: cold cathode fluorescent lamp (CCFL), 105 TV (television set) circuit; 106: INV of the present invention; 112, 112A, 112B, 112C: cold cathode fluorescent lamp (CCFL); 114, 114A, 114B, 114C, 114D, 114E, 114F: electrode, iL, iLA, iLB, iLC, iLD, iLE, iLF: output current; I: all currents; IC: current flowing through electrostatic capacitor CL, IL: load current flowing through impedance devices ZL; C01, C02, C', C: electrostatic capacitor; L', L : inductance; R', R, r1, r2: resistance; CL', CL: floating capacitance of cold cathode fluorescent lamp (CCFL); V, Vd, E', E, Vi: driving voltage; VO, VL: output voltage; ZL, Zi: impedance; $\omega$, $\omega 0$: angular frequency.

**Claims**

1.   A driving circuit of a piezoelectric transformer comprising

    piezoelectric transformers to output a specified voltage to loads;
    a driving unit to apply a voltage used to drive said piezoelectric transformers; and
    a frequency controlling unit to control said driving unit;
    a current detecting unit to transmit a detecting signal to said frequency controlling unit;
    wherein primary sides of every two piezoelectric transformers are serially connected to one another, making up one pair of piezoelectric transformers and one or more pairs of said piezoelectric transformers are connected in parallel to said driving unit and
    wherein one end portion of each of said loads with a same plurality of numbers as for said piezoelectric transformers is connected to each of secondary sides of said piezoelectric transformers and facing end portions each being placed in another end portion of each of said loads are separated into two groups, each group being connected to one another.

2.   The driving circuit of the piezoelectric transformer according to Claim 1 wherein a phase difference in output voltage between two transformers making up said one pair of piezoelectric transformers is 180 degrees.

3. The driving circuit of the piezoelectric transformer according to Claim 1 or Claim 2, wherein said current detecting unit detects a current flowing in each of said facing end portions of said loads.

4. The driving circuit of the piezoelectric transformer according to Claim 3, wherein said current detecting unit is a phase detecting unit to detect a phase difference between load currents.

5. A driving circuit of a piezoelectric transformer comprising:

piezoelectric transformers to output a specified voltage to loads;
a driving unit to apply a voltage used to drive said piezoelectric transformers;
a frequency controlling unit to control said driving unit;
a current detecting unit to transmit a detecting signal to said frequency controlling unit;
wherein primary sides of every two piezoelectric transformers are connected in parallel to one another, making up one pair of piezoelectric transformers and one or more pairs of said piezoelectric transformers are connected in parallel to said driving unit;
wherein one end portion of each of said loads with a same plurality of numbers as for said piezoelectric transformers is connected to each of secondary sides of said piezoelectric transformers and facing end portions each being placed in another end portion of each of said loads are separated into two groups, each group being connected to one another; and
wherein said current detecting unit is a phase detecting unit to detect a phase difference between load currents.

6. A driving circuit of a piezoelectric transformer comprising:

piezoelectric transformers to output a specified voltage to U-shaped cold cathode tubes;
a driving unit to apply a voltage used to drive said piezoelectric transformers;
a frequency controlling unit to control said driving unit;
a current detecting unit to transmit a detecting signal to said frequency controlling unit;
wherein said driving unit is serially connected to every two piezoelectric transformers and said every two piezoelectric transformers is serially connected to said U-shaped cold cathode tubes and,
wherein said current detecting unit detects a phase of each load current flowing in electrodes in said cold cathode tubes.

Fig. 1

EP 1 852 961 A1

Primary circuit | Secondary circuit

105

TV

100    101    103

| A.C. | PFC | POW | INV | CCFL |

102                104

400V

100V

1000V

12V

Fig. 2

Fig. 3

Fig. 4

[1]

[2]

[3]

[4]

Fig. 5

[1]

[2]

Fig. 6

EP 1 852 961 A1

| INTERNATIONAL SEARCH REPORT | International application No. |
|---|---|
| | PCT/JP2006/302931 |

**A. CLASSIFICATION OF SUBJECT MATTER**
*H02M7/48*(2006.01), *H01L41/08*(2006.01), *H02M3/24*(2006.01), *H05B41/24*
(2006.01)

According to International Patent Classification (IPC) or to both national classification and IPC

**B. FIELDS SEARCHED**

Minimum documentation searched (classification system followed by classification symbols)
*H02M7/48*(2006.01), *H01L41/08*(2006.01), *H02M3/24*(2006.01), *H05B41/24*
(2006.01)

Documentation searched other than minimum documentation to the extent that such documents are included in the fields searched
Jitsuyo Shinan Koho        1922-1996    Jitsuyo Shinan Toroku Koho    1996-2006
Kokai Jitsuyo Shinan Koho    1971-2006    Toroku Jitsuyo Shinan Koho    1994-2006

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2003-157990 A  (Hitachi Metals, Ltd.), 30 May, 2003 (30.05.03), Fig. 2(b) (Family: none) | 1-6 |
| X | JP 2001-85759 A  (Hitachi Metals, Ltd.), 30 March, 2001 (30.03.01), Figs. 1, 2 (Family: none) | 1-6 |
| A | JP 10-200174 A  (Tamura Corp.), 31 July, 1998 (31.07.98), Abstract (Family: none) | 1-6 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 02 March, 2006 (02.03.06) | 14 March, 2006 (14.03.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10200174 A